# EUROPEAN PATENT APPLICATION

(11) **EP 4 607 793 A1**
(43) Date of publication of application: **27.08.2025**
(21) Application number: 23893831.0
(22) Date of filing: 21.11.2023
(51) Int. Cl.: H03H 7/01

(54) **RADIO FREQUENCY TRANSMISSION CIRCUIT AND ELECTRONIC DEVICE**

(30) Priority: 24.11.2022 CN 202211487510
(71) Applicant: Huawei Technologies Co., Ltd., Shenzhen, Guangdong 518129 (CN)
(72) Inventor: YANG, Luqian, Shenzhen, Guangdong 518129 (CN); LIU, Daijun, Shenzhen, Guangdong 518129 (CN); HUANG, Dan, Shenzhen, Guangdong 518129 (CN); LI, Qirong, Shenzhen, Guangdong 518129 (CN)
(74) Representative: Gill Jennings & Every LLP
(86) International application number: PCT/CN2023/132936
(87) International publication number: WO 2024/109741

(57) **Abstract**

Embodiments of this application relate to the field of communication technologies and provide a radio frequency transmission circuit and an electronic device, so that a direct current signal can be introduced into a radio frequency line in a simple manner to meet a large radio frequency bandwidth, and costs are low. The radio frequency transmission circuit includes: a first radio frequency input end and a direct current blocking capacitor, where a first end of the direct current blocking capacitor is electrically connected to the first radio frequency input end; a first LC filter, where an input end of the first LC filter is electrically connected to a second end of the direct current blocking capacitor, an output end of the first LC filter is electrically connected to an output end of the radio frequency transmission circuit, and the first LC filter is a low-pass filter; and a direct current input end and a ferrite bead, where the direct current input end is electrically connected to the input end of the first LC filter or between two inductors of the first LC filter through the ferrite bead.

## Description

This application claims priority to Chinese Patent Application No. 202211487510.7, filed with the China National Intellectual Property Administration on November 24, 2022 and entitled "RADIO FREQUENCY TRANSMISSION CIRCUIT AND ELECTRONIC DEVICE", which is incorporated by reference in its entirety.

### TECHNICAL FIELD

This application relates to the field of communication technologies, and in particular, to a radio frequency transmission circuit and an electronic device.

### BACKGROUND

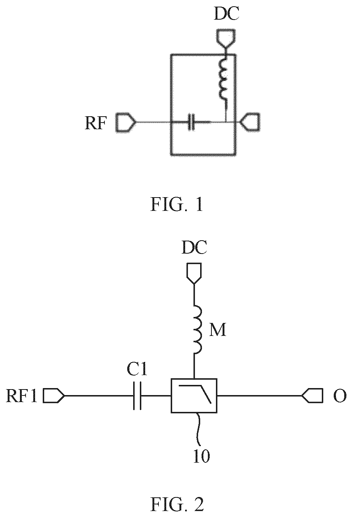

Bias-T (Bias-T) is a working circuit for cascading modules on a base station side, and is usually used at an output end of an external interface. Bias-T can introduce a direct current signal into a cable of a radio frequency signal for transmission. As shown in FIG. 1, a design solution of an inductor and a capacitor is used for conventional Bias-T, and is to introduce a direct current (Direct Current, DC) signal into a line of the radio frequency (Radio Frequency, RF) signal. If a common inductor is used, a radio frequency bandwidth is severely limited, and consequently, Bias-T cannot be applied to a large bandwidth. In another manner, a tapered inductor is used. In this manner, a radio frequency bandwidth is wide. However, this component has a special shape and is fragile, cannot be manufactured through surface mounting, and is easily damaged during processing, assembly, and production debugging. Therefore the entire assembly needs to be completed through manual repair welding after the entire module is surface mounted, resulting in high costs.

### SUMMARY

Technical solutions of this application provide a radio frequency transmission circuit and an electronic device, so that a direct current signal can be introduced into a radio frequency line in a simple manner to meet a large radio frequency bandwidth, and costs are low.

According to a first aspect, a radio frequency transmission circuit is provided. The radio frequency transmission circuit includes: a first radio frequency input end and a direct current blocking capacitor, where a first end of the direct current blocking capacitor is electrically connected to the first radio frequency input end; a first LC filter, where an input end of the first LC filter is electrically connected to a second end of the direct current blocking capacitor, an output end of the first LC filter is electrically connected to an output end of the radio frequency transmission circuit, and the first LC filter is a low-pass filter; and a direct current input end and a ferrite bead, where the direct current input end is electrically connected to the input end of the first LC filter or between two inductors of the first LC filter through the ferrite bead.

In a possible implementation, the first LC filter includes: a first filter inductor, where a first end of the first filter inductor is the input end of the first LC filter; a second filter inductor, where a first end of the second filter inductor is electrically connected to a second end of the first filter inductor, and a second end of the second filter inductor is the output end of the first LC filter; and a filter capacitor, where the filter capacitor is connected in series between the second end of the first filter inductor and a ground end. The direct current input end is electrically connected to the first end of the first filter inductor or the second end of the first filter inductor through the ferrite bead.

In a possible implementation, the radio frequency transmission circuit further includes a second radio frequency input end. The second radio frequency input end and the first radio frequency input end are combined and then electrically connected to the first end of the direct current blocking capacitor.

In a possible implementation, the radio frequency transmission circuit further includes a third radio frequency input end and a second LC filter. An input end of the second LC filter is electrically connected to the third radio frequency input end, and an output end of the second LC filter and the output end of the first LC filter are combined and then electrically connected to the output end of the radio frequency transmission circuit.

In a possible implementation, the second LC filter is a high-pass filter.

In a possible implementation, the radio frequency transmission circuit further includes a fourth radio frequency input end. The fourth radio frequency input end and the third radio frequency input end are combined and then electrically connected to the input end of the second LC filter.

In a possible implementation, the direct current input end is electrically connected to the second end of the first filter inductor through the ferrite bead. A through-current range of the second filter inductor is greater than or equal to 2 A.

In a possible implementation, the direct current input end is electrically connected to the first end of the first filter inductor through the ferrite bead. Through-current ranges of the first filter inductor and the second filter inductor are greater than or equal to 2 A.

In a possible implementation, withstand voltages of the direct current blocking capacitor and the filter capacitor are greater than or equal to 50 V.

In a possible implementation, the first filter inductor and the second filter inductor are adjustable inductors; and the filter capacitor is an adjustable capacitor.

In a possible implementation, the radio frequency transmission circuit further includes a third inductor connected in series between the direct current input end and the ferrite bead.

According to a second aspect, an electronic device is provided. The electronic device includes the foregoing radio frequency transmission circuit.

According to the radio frequency transmission circuit and the electronic device in an embodiment of this application, a first LC filter for low-pass filtering is connected in series between a first radio frequency input end and an output end. A direct current signal is introduced into the first LC filter through a ferrite bead. Because the ferrite bead has large impedance at a low frequency compared with an inductor, crosstalk of a low-frequency signal from the first radio frequency input end on a direct current path can be reduced. In addition, an adverse impact of a signal after the first LC filter on the direct current path can be suppressed by using the first LC filter, so that a signal of a higher frequency can be introduced after the first LC filter to meet a large radio frequency bandwidth. In addition, a direct current blocking capacitor is disposed between the first radio frequency input end and the first LC filter to prevent an adverse impact of the introduced direct current signal on the first radio frequency input end. Moreover, a tapered inductor is not required, and the direct current signal is introduced into a radio frequency line in a simple manner, so that a processing process is simple, no special process is required, and costs are low.

### BRIEF DESCRIPTION OF DRAWINGS

FIG. 1 is a diagram of a circuit of Bias-T in the conventional technology;
FIG. 2 is a diagram of a structure of a radio frequency transmission circuit according to an embodiment of this application;
FIG. 3 is a diagram of a structure of another radio frequency transmission circuit according to an embodiment of this application;
FIG. 4 is a diagram of a structure of another radio frequency transmission circuit according to an embodiment of this application;
FIG. 5 is a diagram of a structure of another radio frequency transmission circuit according to an embodiment of this application;
FIG. 6 is a diagram of a structure of another radio frequency transmission circuit according to an embodiment of this application; and
FIG. 7 is a diagram of a structure of another radio frequency transmission circuit according to an embodiment of this application.

### DESCRIPTION OF EMBODIMENTS

Terms used in embodiments of this application are only used to explain specific embodiments of this application, but are not intended to limit this application.

A technical solution in embodiments of this application may be applied to various communication systems, for example, a long term evolution (long term evolution, LTE) system, a 5^{th} generation (5^{th} generation, 5G) mobile communication system, and a future mobile communication system. As shown in FIG. 2, an embodiment of this application provides a radio frequency transmission circuit, including: a first radio frequency input end RF1 and a direct current blocking capacitor C1, where a first end (that is, a left end) of the direct current blocking capacitor C1 is electrically connected to the first radio frequency input end RF1; a first LC filter 10, where an input end of the first LC filter 10 is electrically connected to a second end (that is, a right end) of the direct current blocking capacitor C1, an output end of the first LC filter 10 is electrically connected to an output end O of the radio frequency transmission circuit, and the first LC filter 10 is a low-pass filter; and a direct current input end DC and a ferrite bead M, where the direct current input end DC is electrically connected to the input end of the first LC filter 10 through the ferrite bead M, or the direct current input end DC is electrically connected between two inductors of the first LC filter 10 through the ferrite bead M. In other words, a direct current signal introduced by the direct current input end DC and the ferrite bead M needs to be combined with a radio frequency signal input by the first radio frequency input end RF1, and then transmitted to the output end O of the radio frequency transmission circuit through at least a part of a first LC. That is, a function of Bias-T is implemented through the foregoing circuit structure, and a direct current signal is introduced into a radio frequency path and is combined with a radio frequency signal for output.

Specifically, an LC filter is also referred to as a passive filter, and is a filter circuit formed by a combination of an inductor and a capacitor. The first LC filter 10 is the low-pass filter, and is configured to allow a low-frequency component or a direct current component in a signal to pass, and suppress a high frequency component or interference and noise. A low-frequency radio frequency signal may be input at the first radio frequency input end RF1. Through a high-frequency suppression effect of the first LC filter 10, a frequency band requirement for high impedance of the ferrite bead M is reduced, so that the ferrite bead M only needs to maintain high impedance in a low-frequency band. That is, a low-frequency signal input at the first radio frequency input end RF1 does not cause crosstalk to a direct current path of the ferrite bead M, and the ferrite bead M has little impact on performance of a radio frequency path. Through a high-frequency suppression feature of at least some inductors in the first LC filter 10, formation of resonance between the direct current path and the radio frequency path may be suppressed. In other words, an adverse impact of a signal on a path after the first LC filter 10 in the circuit on the ferrite bead M on the direct current path can be suppressed. In this way, a signal of a higher frequency is introduced after the first LC filter 10 to meet a large radio frequency bandwidth.

According to the radio frequency transmission circuit in this embodiment of this application, a first LC filter for low-pass filtering is connected in series between a first radio frequency input end and an output end. A direct current signal is introduced into the first LC filter through a ferrite bead. Because the ferrite bead has large impedance at a low frequency compared with an inductor, crosstalk of a low-frequency signal from the first radio frequency input end on a direct current path can be reduced. In addition, an adverse impact of a signal after the first LC filter on the direct current path can be suppressed by using the first LC filter, so that a signal of a higher frequency can be introduced after the first LC filter to meet a large radio frequency bandwidth. In addition, a direct current blocking capacitor is disposed between the first radio frequency input end and the first LC filter to prevent an adverse impact of the introduced direct current signal on the first radio frequency input end. Moreover, a tapered inductor is not required, and the direct current signal is introduced into a radio frequency line in a simple manner, so that a processing process is simple, no special process is required, and costs are low.

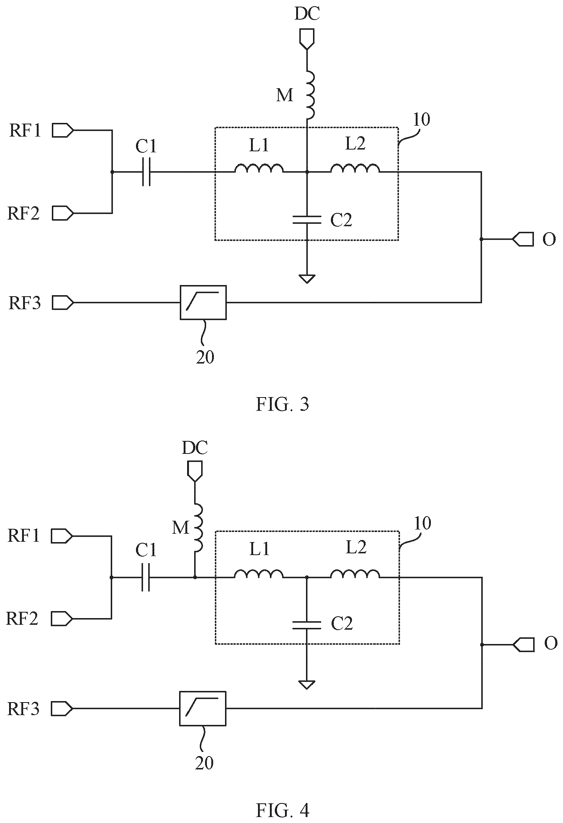

In a possible implementation, as shown in FIG. 3, the first LC filter 10 includes: a first filter inductor L1, where a first end (that is, a left end) of the first filter inductor L1 is the input end of the first LC filter 10; a second filter inductor L2, where a first end (that is, a left end) of the second filter inductor L2 is electrically connected to a second end (that is, a right end) of the first filter inductor L1, and a second end (that is, a right end) of the second filter inductor L2 is the output end of the first LC filter 10; and a filter capacitor C2, where the filter capacitor C2 is connected in series between the second end of the first filter inductor L1 and a ground end. It should be noted that a specific implementation of the ground end is not limited in this embodiment of this application, provided that a potential can be provided, so that a current loop is formed in a circuit based on the ground end, and the circuit can work normally. The direct current input end DC is electrically connected to the second end of the first filter inductor L1 through the ferrite bead M, or as shown in FIG. 4, the direct current input end DC is electrically connected to the first end of the first filter inductor L1 through the ferrite bead M.

In a possible implementation, as shown in FIG. 3 or FIG. 4, the radio frequency transmission circuit further includes a second radio frequency input end RF2. The second radio frequency input end RF2 and the first radio frequency input end RF1 are combined and then electrically connected to the first end of the direct current blocking capacitor C1. Low-frequency radio frequency signals may be input at both the first radio frequency input end RF1 and the second radio frequency input end RF2 and combined, via the direct current blocking capacitor C1 after being combined, with a direct current signal introduced through the ferrite bead M.

In a possible implementation, as shown in FIG. 3 or FIG. 4, the radio frequency transmission circuit further includes a third radio frequency input end RF3 and a second LC filter 20. An input end of the second LC filter 20 is electrically connected to the third radio frequency input end RF3, and an output end of the second LC filter 20 and the output end of the first LC filter 10 are combined and then electrically connected to the output end O of the radio frequency transmission circuit. In other words, signals finally combined and output by the radio frequency transmission circuit may include radio frequency signals from the first radio frequency input end RF1, the second radio frequency input end RF2, and the third radio frequency input end RF3, and a direct current signal from the direct current input end DC. Due to high-frequency suppression features of at least some inductors in the first LC filter 10, an adverse impact of a radio frequency signal from the third radio frequency input end RF3 in the circuit on the ferrite bead M on the direct current path is suppressed. In this way, a signal of a higher frequency can be introduced through the third radio frequency input end RF3, to meet a large radio frequency bandwidth. In the structure shown in FIG. 3, the second filter inductor L2 can suppress the adverse impact of the radio frequency signal from the third radio frequency input end RF3 on the ferrite bead M on the direct current path. In the structure shown in FIG. 4, the first filter inductor L1 and the second filter inductor L2 can suppress the adverse impact of the radio frequency signal from the third radio frequency input end RF3 on the ferrite bead M.

In a possible implementation, as shown in FIG. 3 or FIG. 4, the second LC filter 20 is a high-pass filter, that is, a high-frequency signal can be input at the third radio frequency input end RF3. The entire radio frequency transmission circuit can implement combined transmission of a total of four signals, including a low-frequency signal, a high-frequency signal, and a direct current signal, to reduce a quantity of external interfaces and simplify a transmission circuit structure, so that costs are reduced.

In a possible implementation, as shown in FIG. 4, the direct current input end DC is electrically connected to the second end of the first filter inductor L1 through the ferrite bead M. A through-current range of the second filter inductor L2 is greater than or equal to 2 A. In the circuit structure shown in FIG. 4, the second filter inductor L2 is used to suppress resonance between the direct current path on which the ferrite bead M is located and a radio frequency path on which the second LC filter 20 is located. Therefore, the second filter inductor L2 is set to have a large through-current range, so as to reduce an adverse impact caused by a large current on the radio frequency path on which the second LC filter 20 is located.

In a possible implementation, as shown in FIG. 3, the direct current input end DC is electrically connected to the first end of the first filter inductor L1 through the ferrite bead M. Through-current ranges of the first filter inductor L1 and the second filter inductor L2 are greater than or equal to 2 A. In the circuit structure shown in FIG. 3, the first filter inductor L1 and the second filter inductor L2 are jointly used to suppress the resonance between the direct current path on which the ferrite bead M is located and the radio frequency path on which the second LC filter 20 is located. Therefore, the first filter inductor L1 and the second filter inductor L2 are set to have large through-current ranges, so as to reduce the adverse impact caused by the large current on the radio frequency path on which the second LC filter 20 is located.

In a possible implementation, withstand voltages of the direct current blocking capacitor C1 and the filter capacitor C2 are greater than or equal to 50 V, to reduce an adverse impact on a radio frequency path after the direct current path on which the ferrite bead M is located is introduced.

As shown in FIG. 3 and FIG. 4, two types of low-frequency signals provided by the first radio frequency input end RF1 and the second radio frequency input end RF2 are combined and then pass through the first LC filter 10, and the first LC filter 10 mainly eliminates an impact of a signal of a high-frequency bandwidth on the two types of low-frequency signals. That is, the first LC filter 10 has both a suppressing capability for a radio frequency signal of a high frequency and a through-current capability of a direct current signal. The through-current capability is improved by selecting of through-current capabilities of at least some filter inductors in the first LC filter 10, and selecting of voltage withstanding capabilities of the direct current blocking capacitor C1 and filter capacitor C2.

In a possible implementation, the first filter inductor L1 and the second filter inductor L2 are adjustable inductors; and the filter capacitor C2 is an adjustable capacitor.

According to the radio frequency transmission circuit in this embodiment of this application, the direct current path is connected in series with the ferrite bead M and then is connected to the input end of the first LC filter 10 or the first LC filter 10. Generally, the ferrite bead M may maintain a high impedance state for an alternating current signal in a 4G frequency band. Through isolation of a radio frequency signal in the first LC filter 10, the ferrite bead M directly establishes a connection with the radio frequency path only in a low-frequency band. The ferrite bead M in this frequency band is in the high impedance state, so that the ferrite bead M has a minimum impact on performance of the radio frequency path in a full frequency band. At least some inductors in the first LC filter 10 are set to be inductors having a large through-current capability, and a capacitance value and an inductance value of the first LC filter 10 are fine-tuned by using a feature of high robustness of the first LC filter 10, so that a capability of the first LC filter 10 to suppress a radio frequency signal can be improved. The direct current blocking capacitor C1 and the filter capacitor C2 that are directly connected to the direct current path on which the ferrite bead M is located are selected to be capacitors with strong voltage withstanding capabilities, so as to further reduce an adverse impact of introduction of the direct current path on the radio frequency path. The circuit structure is simple, and selected components are common components that are temperature-resistant and voltage-withstanding. DC to 7 GHz signal transmission can be implemented without a similar inductor-type fragile component. The processing process is simple, no special or complex process is required, and costs are low.

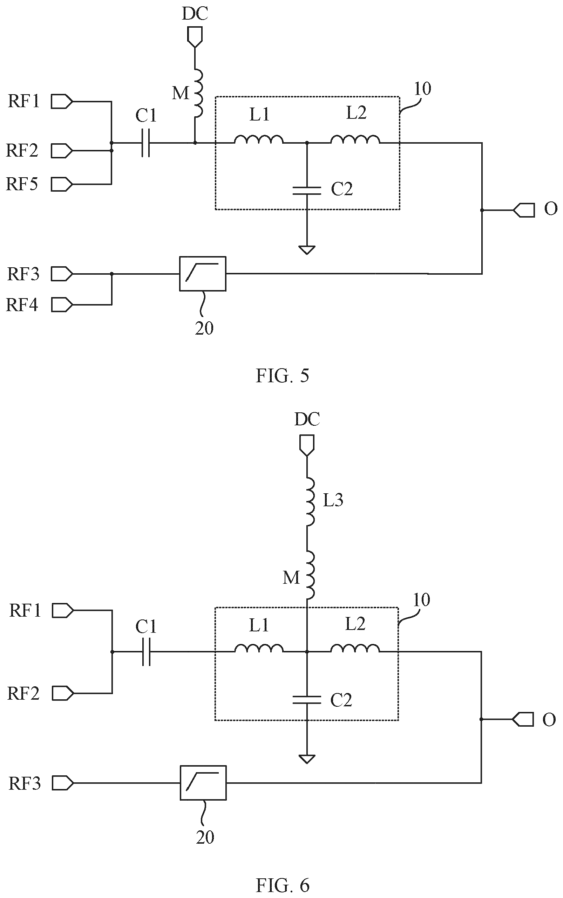

In a possible implementation, as shown in FIG. 5, the radio frequency transmission circuit further includes a fourth radio frequency input end RF4. The fourth radio frequency input end RF4 and the third radio frequency input end RF3 are combined and then electrically connected to the input end of the second LC filter 20. In other words, the radio frequency path on which the second LC filter 20 is located may transmit a signal obtained by combining radio frequency signals from a plurality of radio frequency input ends, and radio frequency signals input at the third radio frequency input end RF3 and the fourth radio frequency input end RF4 may be high frequency signals. It can be understood that, in another possible implementation, more radio frequency input ends may also be electrically connected to the input end of the second LC filter 20. That is, a quantity of radio frequency signals combined on the radio frequency path on which the second LC filter 20 is located is not limited in this embodiment of this application. Similarly, more radio frequency input ends may also be electrically connected to the input end of the first LC filter 10. For example, the radio frequency transmission circuit further includes a fifth radio frequency input end RF5. The fifth radio frequency input end RF5, the first radio frequency input end RF1, and the second radio frequency input end RF2 are combined and then electrically connected to the input end of the first LC filter 10. Low-frequency signals may be input at the first radio frequency input end RF1, the second radio frequency input end RF2, and the fifth radio frequency input end RF5. That is, a quantity of radio frequency signals combined on the radio frequency path on which the first LC filter 10 is located is not limited in this embodiment of this application. In other words, for any combination of multi-frequency signals and a direct current signal, corresponding differentiation may be performed by using an LC filter, and then a ferrite bead is introduced and is connected to the LC filter structure, to achieve an objective of combining a direct current path and a radio frequency path.

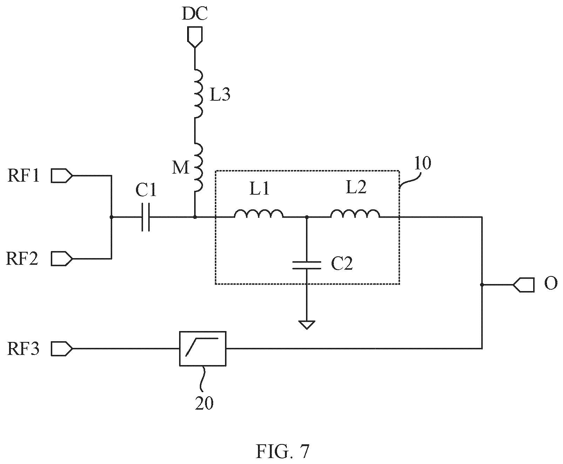

In a possible implementation, as shown in FIG. 6 and FIG. 7, the radio frequency transmission circuit further includes a third inductor L3 connected in series between the direct current input end DC and the ferrite bead M. The third inductor L3 is set, so that a frequency of a radio frequency signal introduced at the input end of the first LC filter 10 can be increased. For example, after the second radio frequency input end RF2 to be combined with the first radio frequency input end RF1 is introduced, a bandwidth of a path on which the first LC filter 10 is located is increased. If the increased bandwidth cannot meet a requirement of the ferrite bead M, the third inductor L3 may be additionally connected in series between the ferrite bead M and the direct current input end DC, so that an equivalent impedance of the third inductor L3 and the ferrite bead M after being connected in series can support a larger bandwidth after combination. In addition, after the third inductor L3 is additionally connected in series between the direct current input end DC and the ferrite bead M, a through-current range of the third inductor L3 may be set to be greater than or equal to 2 A. In other words, the third inductor L3 is set to have a large through-current range, to reduce an adverse impact caused by a large current on a radio frequency path on which the second LC filter 20 is located. Therefore, the second filter inductor L2 in FIG. 6 does not need to be set to have a large through-current range, and the first filter inductor L1 and the second filter inductor L2 in FIG. 7 do not need to be set to have a large through-current range.

An embodiment of this application further provides an electronic device, including the radio frequency transmission circuit in any embodiment described above.

The electronic device may be any network device having a radio frequency transmission function. For example, in a scenario in which signals of small cells are cascaded, two low-frequency signals, one direct current signal, and one radio frequency signal need to be combined into one signal for external transmission. The network device in this scenario may include the radio frequency transmission circuit in this embodiment of this application.

The network device may be, for example, an access network device. The access network device may also be referred to as a radio access network (radio access network, RAN) device, and is a device that provides a wireless communication function for a terminal device. The access network device includes, for example, but is not limited to, a next generation nodeB (next generation nodeB, gNB), an evolved nodeB (evolved nodeB, eNB), a baseband unit (baseband unit, BBU), a transmission reception point (transmission reception point, TRP), and a transmission point (transmission point, TP) in 5G, a base station in a future mobile communication system, or an access point in a Wi-Fi system. Alternatively, the access network device may be a radio controller, a central unit (central unit, CU), and/or a distributed unit (distributed unit, DU) in a cloud radio access network (cloud radio access network, CRAN) scenario. The network device may alternatively be a relay station, a vehicle-mounted device, a network device in a future evolved PLMN network, or the like. The network device may alternatively be a network device in a future 6G network, or the like. The network device may be a macro base station, or may be a micro base station. A coverage area of the network device may include one cell, or may include a plurality of cells.

In embodiments of this application, an apparatus configured to implement a function of the network device may be the network device, or may be an apparatus that can support the network device in implementing the function, for example, a chip system.

In embodiments of this application, "at least one" means one or more, and "a plurality of" means two or more. "And/or" describes an association relationship for describing associated objects and represents that three relationships may exist. For example, A and/or B may represent the following three cases: Only A exists, both A and B exist, and only B exists. A and B may be singular or plural. A character "/" generally indicates an "or" relationship between the associated objects. "At least one of the following" and similar expressions refer to any combination of these items, including any combination of a single item or a plurality of items. For example, at least one of a, b, and c may represent: a, b, c, a-b, a-c, b-c, or a-b-c, where a, b, and c may be a single or a plurality.

The foregoing descriptions are merely example embodiments of this application, and are not intended to limit this application. For a person skilled in the art, this application may have various modifications and variations. Any modification, equivalent replacement, or improvement made without departing from the spirit and principle of this application shall fall within the protection scope of this application.

## Claims

1. A radio frequency transmission circuit, comprising:
a first radio frequency input end and a direct current blocking capacitor, wherein a first end of the direct current blocking capacitor is electrically connected to the first radio frequency input end;
a first LC filter, wherein an input end of the first LC filter is electrically connected to a second end of the direct current blocking capacitor, an output end of the first LC filter is electrically connected to an output end of the radio frequency transmission circuit, and the first LC filter is a low-pass filter; and
a direct current input end and a ferrite bead, wherein the direct current input end is electrically connected to the input end of the first LC filter or between two inductors of the first LC filter through the ferrite bead.

2. The radio frequency transmission circuit according to claim 1, wherein
the first LC filter comprises:
a first filter inductor, wherein a first end of the first filter inductor is the input end of the first LC filter;
a second filter inductor, wherein a first end of the second filter inductor is electrically connected to a second end of the first filter inductor, and a second end of the second filter inductor is the output end of the first LC filter; and
a filter capacitor, wherein the filter capacitor is connected in series between the second end of the first filter inductor and a ground end; and
the direct current input end is electrically connected to the first end of the first filter inductor or the second end of the first filter inductor through the ferrite bead.

3. The radio frequency transmission circuit according to claim 2, further comprising:
a second radio frequency input end, wherein the second radio frequency input end and the first radio frequency input end are combined and then electrically connected to the first end of the direct current blocking capacitor.

4. The radio frequency transmission circuit according to any one of claims 1 to 3, further comprising:
a third radio frequency input end; and
a second LC filter, wherein an input end of the second LC filter is electrically connected to the third radio frequency input end, and an output end of the second LC filter and the output end of the first LC filter are combined and then electrically connected to the output end of the radio frequency transmission circuit.

5. The radio frequency transmission circuit according to claim 4, wherein
the second LC filter is a high-pass filter.

6. The radio frequency transmission circuit according to claim 4, further comprising:
a fourth radio frequency input end, wherein the fourth radio frequency input end and the third radio frequency input end are combined and then electrically connected to the input end of the second LC filter.

7. The radio frequency transmission circuit according to claim 2, wherein
the direct current input end is electrically connected to the second end of the first filter inductor through the ferrite bead; and
a through-current range of the second filter inductor is greater than or equal to 2 A.

8. The radio frequency transmission circuit according to claim 2, wherein
the direct current input end is electrically connected to the first end of the first filter inductor through the ferrite bead; and
through-current ranges of the first filter inductor and the second filter inductor are greater than or equal to 2 A.

9. The radio frequency transmission circuit according to claim 2, wherein
withstand voltages of the direct current blocking capacitor and the filter capacitor are greater than or equal to 50 V.

10. The radio frequency transmission circuit according to claim 2, wherein
the first filter inductor and the second filter inductor are adjustable inductors; and
the filter capacitor is an adjustable capacitor.

11. The radio frequency transmission circuit according to any one of claims 1 to 10, further comprising:
a third inductor connected in series between the direct current input end and the ferrite bead.

12. An electronic device, comprising the radio frequency transmission circuit according to any one of claims 1 to 11.
